# EUROPEAN PATENT APPLICATION

(11) **EP 0 908 947 A2**
(43) Date of publication of application: **14.04.1999**
(21) Application number: 98118296.7
(22) Date of filing: 28.09.1998
(51) Int. Cl.: H01L 21/8238

(54) **Method for fabricating semiconductor device with pMIS transistor**

(30) Priority: 29.09.1997 JP 264286/97
(71) Applicant: Matsushita Electronics Corporation, Takatsuki-shi, Osaka 569-1193 (JP)
(72) Inventor: Arai, Masatoshi, Ikoma-shi, Nara 630-0225 (JP)
(74) Representative: Grünecker, Kinkeldey, Stockmair & Schwanhäusser Anwaltssozietät

(57) **Abstract**

A gate oxide film and a polycrystalline silicon film are sequentially formed on a silicon substrate, and fluorine ions are implanted into the entire polycrystalline silicon film at a dose in the range from 2 × 10¹⁴ cm⁻² to 2 × 10¹⁵ cm⁻². A gate electrode and a gate oxide film are formed by patterning the polycrystalline silicon film and a silicon dioxide film. Then, n-type and p-type doped layers, which are to constitute source/drain regions for each transistor, are formed. Thereafter, rapid thermal annealing is conducted, thereby diffusing fluorine from the gate electrode into the gate oxide film. Since an appropriate amount of fluorine has been introduced into the gate oxide film, the physical stress on the gate oxide film can be reduced and the passage of boron into the substrate can be suppressed.

## Description

### BACKGROUND OF THE INVENTION

The present invention relates to an improved method for fabricating a semiconductor device including a highly reliable pMIS transistor with physical stress on the gate insulating film thereof reduced.

Recently, as an MIS transistor in a semiconductor device has been downsized, the thickness of the gate insulating film thereof has also been reduced. However, as is well known, if a very thin gate insulating film is provided to have a thickness of several nm or less, then the reliability of the gate insulating film is deteriorated. This is because the physical stress applied on the gate insulating film cannot be sufficiently reduced owing to the difference between the thermal expansion coefficient of a gate electrode and that of the gate insulating film. Accordingly, it is widely recognized that technology for improving the reliability of a gate insulating film plays a significant role in implementing such a thin gate insulating film.

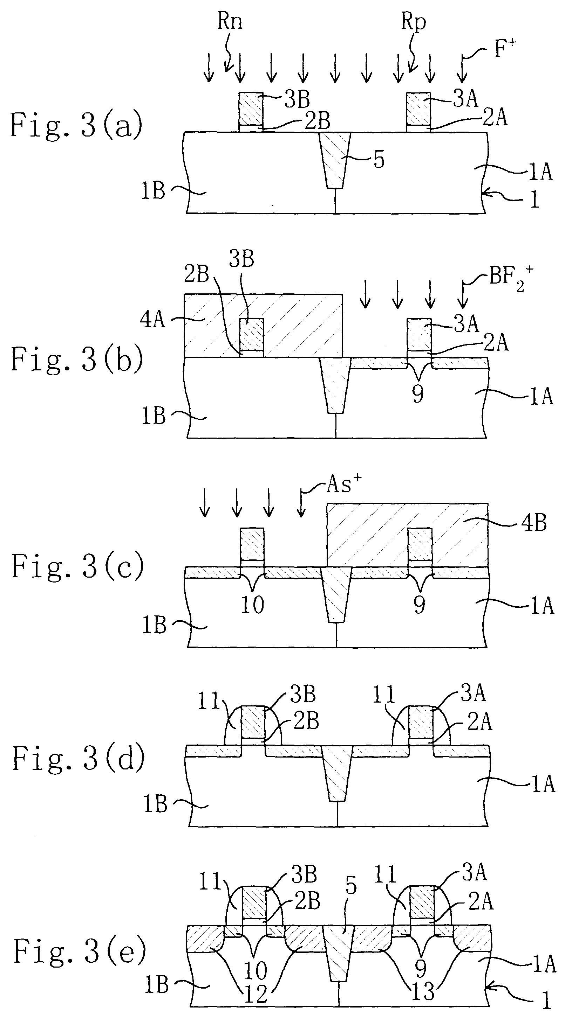

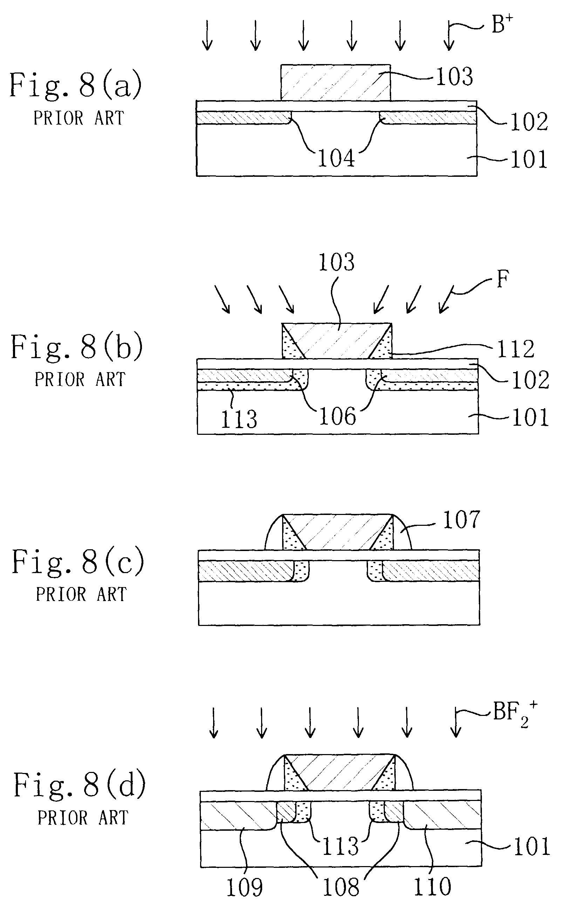

An example of such technology is disclosed in Japanese Laid-Open Publication No. 9-252117, in which the physical stress applied on a gate insulating film is reduced to a certain degree by doping the gate insulating film with fluorine. Figures **8(a)** through **8(d)** are cross-sectional views illustrating an extract of the process steps for fabricating a pMOS transistor as disclosed in Figures **3(a)** through **3(i)** of the publication.

First, in the process step shown in Figure **8(a)**, a gate insulating film **102** and a gate electrode **103** are formed on an n-type semiconductor layer (silicon substrate) **101**, and boron (B⁺) ions are implanted into the entire substrate, thereby forming a p⁺ layer **104**.

Next, in the process step shown in Figure **8(b)**, fluorine (F⁺) ions are implanted at a certain tilt angle on the conditions that the acceleration voltage is set at 40 keV and the dose is set at 1 × 10¹⁴ cm⁻². Thereafter, heat treatment is conducted to diffuse boron ions, thereby turning the major part of the gate electrode **103** into a p-type region and turning the side portions of the gate electrode **103** into a high-resistance layer **112**. On the other hand, since boron ions also diffuse in the substrate, the p⁺ layer **104** is turned into a p layer **106** and an end layer (fluorine-doped layer) **113** is formed to surround the p layer **106**.

Then, in the process step shown in Figure **8(c)**, insulator sidewalls **107** are formed on the side surfaces of the gate electrode **103**.

Subsequently, in the process step shown in Figure **8(d)**, boron fluoride (BF₂⁺) ions are implanted on the conditions that the acceleration voltage is set in the range from 30 keV to 50 keV and the dose is set in the range from 1 × 10¹⁵ cm⁻² to 1 × 10¹⁶ cm⁻² and then heat treatment is conducted, thereby forming a highly-doped source region **109**, a highly-doped drain region **110**, a lightly-doped layer **108** (parts of the p layer **106**) as a so-called LDD layer and the end layer **113**.

In a pMOS transistor having such a structure, by promoting the diffusion of boron ions in the gate electrode **103** with the implantation of fluorine ions, fluorine ions can be doped into the gate insulating film **102** at a high doping level. As a result, the stress applied into the gate insulating film **102** owing the difference between the thermal expansion coefficient of the gate electrode **103** and that of the gate insulating film **102** can be reduced. In addition, since fluorine ions have been doped into the substrate, the diffusion of boron ions can be suppressed and therefore a shallow junction can be formed. It is noted that the high-resistance layer **112** is formed in the gate electrode **103** in order to increase the breakdown voltage thereof.

However, it was recently found that various inconveniences are caused because boron ions, diffusing in the gate electrode, are likely to enter the substrate. That is to say, a "boron passage" phenomenon happens and adversely varies the threshold voltage of a pMIS transistor from a predetermined value. Specifically, boron ions, which have been implanted into the gate electrode of a pMIS transistor, are likely to pass through a thin gate insulating film to diffuse into the substrate during a subsequent heat treatment. The variation in threshold voltages of a pMIS transistor also causes various problems in a so-called "dual-gate-type semiconductor device", in which a gate electrode made of n⁺-type polycrystalline silicon and a gate electrode made of p⁺-type polycrystalline silicon are used for nMIS and pMIS transistors, respectively.

Moreover, as will be discussed in further detail later, it was also brought to light that the reliability of a gate insulating film is disadvantageously deteriorated because of the accumulation of boron ions in the gate insulating film. In accordance with the technology disclosed in the above-identified publication, the reliability of a gate insulating film is allegedly improved by reducing the stress applied into the gate insulating film through the introduction of fluorine ions into the gate insulating film. However, the reliability of the gate insulating film is still deteriorated because of a different reason, i.e., not only fluorine ions but also boron ions enter the gate insulating film.

### SUMMARY OF THE INVENTION

In view of the above-described conventional problems, the present invention was made to accomplish the object of providing a method for fabricating a semiconductor device that can improve the reliability of a gate insulating film and prevent the characteristics of a pMIS transistor from varying by modifying the conditions on which fluorine ions are implanted into a gate electrode.

A first method for fabricating a semiconductor device according to the present invention includes the steps of: a) sequentially forming a gate insulating film and a semiconductor film over a region of a semiconductor substrate where a pMIS transistor is to be formed; b) forming a gate electrode for the pMIS transistor by patterning the semiconductor film; c) introducing an impurity containing fluorine into the gate electrode of the pMIS transistor in accordance with ion implantation technique such that the dose of fluorine is in the range from 2 × 10¹³ cm⁻² to 2 × 10¹⁵ cm⁻² before or after the step b) is performed; d) introducing boron into the gate electrode of the pMIS transistor; e) forming source/drain regions for the pMIS transistor by introducing a p-type impurity into the semiconductor substrate; and f) diffusing fluorine in the gate electrode to the gate insulating film by conducting a heat treatment.

It was confirmed that a pMIS transistor formed in accordance with this method has advantageous characteristics as follows. First, since fluorine is introduced into the gate insulating film of the pMIS transistor in the step c), the physical stress applied on the gate insulating film because of the difference between the thermal expansion coefficient of the gate electrode and that of the gate insulating film can be reduced. As a result, the reliability of the transistor can be improved. In addition, since fluorine is also introduced into the gate electrode in accordance with ion implantation technique at a dose in the range from 2 × 10¹³ cm⁻² to 2 × 10¹⁵ cm⁻², it is possible to prevent boron, which is introduced into the gate electrode in the step d), from entering the gate insulating film and the semiconductor substrate. As a result, we confirmed the characteristics of the transistor are not varied and the reliability thereof is not deteriorated.

In one embodiment of the present invention, the step c) may be performed to introduce the impurity containing fluorine into the entire surface of the semiconductor film after the step a) has been performed and before the step b) is performed.

In such an embodiment, the steps c) and d) may be performed simultaneously by introducing boron fluoride as the impurity containing fluorine into the entire surface of the semiconductor film after the step a) has been performed and before the step b) is performed. The method may further include the step of forming a protective insulating film over the semiconductor film after the steps c) and d) have been performed. In the step b), not only the gate electrode but also the protective insulating film may be patterned. And the step e) may be performed by implanting p-type impurity ions with the gate electrode, covered with the protective insulating film, used as a mask. Then, the doping level of boron in the gate electrode and that of the p-type impurity in the source/drain regions in the semiconductor substrate can be independently controlled at respectively appropriate values.

In another embodiment of the present invention, the steps c) and d) may be performed simultaneously by introducing boron fluoride as the impurity containing fluorine. In such an embodiment, the process can be simplified.

In still another embodiment of the present invention, the step c) may be performed to introduce the impurity containing fluorine into the gate electrode and the semiconductor substrate after the step b) has been performed. In such an embodiment, since the diffusion of boron in the semiconductor substrate can be suppressed, a shallow junction can be formed easily.

In still another embodiment of the present invention, the step c) may be performed by implanting ions of single-element fluorine. And the steps d) and e) may be performed by introducing single-element boron into the semiconductor substrate with the gate electrode used as a mask after the step b) has been performed. Then, the doping levels of fluorine and boron can be independently controlled at respectively appropriate values.

In still another embodiment, in the step c), the impurity containing fluorine is more preferably introduced in accordance with ion implantation technique such that the dose of fluorine is 2 × 10¹⁴ cm⁻² or more.

In still another embodiment, the method preferably further includes, prior to the step e), the steps of: forming an LDD region for the pMIS transistor by introducing a p-type impurity into the semiconductor substrate with the gate electrode used as a mask, and forming insulator sidewalls on side surfaces of the gate electrode of the pMIS transistor. The step e) is preferably performed by using the insulator sidewalls and the gate electrode as a mask. In such an embodiment, a highly reliable pMIS transistor having stable characteristics can be obtained even though the transistor has a so-called "LDD structure".

In still another embodiment, in the step a), the gate insulating film and the semiconductor film may be formed so as to also cover a region of the semiconductor substrate where an nMIS transistor is to be formed. In the step b), a gate electrode for the nMIS transistor may be formed by patterning the semiconductor film. In the step c), the impurity containing fluorine may also be introduced in accordance with ion implantation technique into the gate electrode of the nMIS transistor. The method may further include the step of forming source/drain regions for the nMIS transistor by introducing an n-type impurity into the region of the semiconductor substrate where the nMIS transistor is to be formed with the gate electrode for the nMIS transistor used as a mask. In such an embodiment, a complementary MIS transistor is formed. Since fluorine is also introduced into the gate insulating film of the nMIS transistor, the reliability of the nMIS transistor is also improved because of the above-described functions.

A second method for fabricating a semiconductor device according to the present invention includes the steps of: a) sequentially forming a gate insulating film and a semiconductor film over respective regions of a semiconductor substrate where nMIS and pMIS transistors are to be formed; b) forming respective gate electrodes for the nMIS and the pMIS transistors by patterning the semiconductor film; c) forming p-type lightly-doped source/drain regions in the region where the pMIS transistor is to be formed by introducing boron fluoride into the gate electrodes and the entire semiconductor substrate in accordance with ion implantation technique after the step b) has been performed; d) forming n-type lightly-doped source/drain regions in the region of the semiconductor substrate where the nMIS transistor is to be formed by introducing an n-type impurity at a level higher than that of boron fluoride; e) forming insulator sidewalls on side surfaces of each said gate electrode; f) forming p-type highly-doped source/drain regions in the region of the semiconductor substrate where the pMIS transistor is to be formed by introducing a p-type impurity thereto with the gate electrode and the insulator sidewalls used as a mask; g) forming n-type highly-doped source/drain regions in the region of the semiconductor substrate where the nMIS transistor is to be formed by introducing an n-type impurity thereto with the gate electrode and the insulator sidewalls used as a mask; and h) diffusing fluorine in the gate electrodes to the gate insulating film by conducting a heat treatment.

In accordance with this method, a semiconductor device including highly reliable pMIS and nMIS transistors with stable characteristics can be obtained, even though the pMIS and nMIS transistors both have a so-called "LDD structure". In addition, since the introduction of fluorine into the gate electrode and the formation of an LDD region in the pMIS transistor are simultaneously performed during a single process step, the number of process steps and the fabrication costs of a semiconductor device can both be reduced.

### BRIEF DESCRIPTION OF THE DRAWINGS

Figures **1(a)** through **1(e)** are cross-sectional views illustrating the process steps for fabricating a semiconductor device in the first embodiment in which fluorine ions are implanted into the entire polycrystalline silicon film before gate electrodes are formed.
Figures **2(a)** through **2(e)** are cross-sectional views illustrating the process steps for fabricating a semiconductor device in the second embodiment in which fluorine ions are implanted after gate electrodes have been formed.
Figures **3(a)** through **3(e)** are cross-sectional views illustrating the process steps for fabricating a semiconductor device in the third embodiment in which the present invention is applied to forming a semiconductor device having an LDD structure.
Figures **4(a)** through **4(e)** are cross-sectional views illustrating the process steps for fabricating a semiconductor device in the third embodiment in which the introduction of fluorine into gate electrodes and the formation of LDD regions for a pMIS transistor are simultaneously realized by implanting boron fluoride ions.
Figure **5** is a graph illustrating the dependence of **Q**_{**BD**} (charge to breakdown) on the dose of BF₂⁺ (boron fluoride).
Figure **6** is a graph illustrating the dependence of a flat-band voltage on the dose of BF₂⁺.
Figure **7** is a graph illustrating how C-V waveforms differ depending on whether fluorine is doped or not.
Figures **8(a)** through **8(d)** are cross-sectional views illustrating conventional process steps for fabricating a semiconductor device.

### DETAILED DESCRIPTION OF THE INVENTION

### EMBODIMENT 1

In this embodiment, a semiconductor device, in which pMOS transistors and nMOS transistors coexist, will be described.

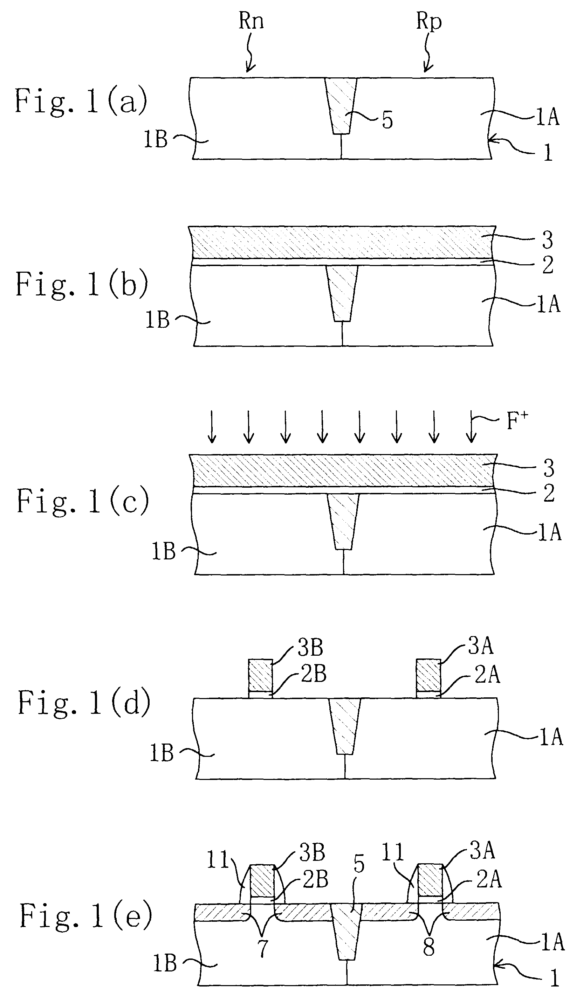

Figures **1(a)** through **1(e)** are cross-sectional views illustrating a method for fabricating a semiconductor device in the first embodiment of the present invention.

First, in the process step shown in Figure **1(a)**, an n-well **1A** and a p-well **1B** are formed in respective regions **Rp** and **Rn** of a silicon substrate **1** where pMOS and nMOS transistors are to be formed. In this specification, these regions will be referred to as "pMOS transistor forming region" and "nMOS transistor forming region". Then, an element isolation region **5** is formed to electrically isolate these regions from each other.

Next, in the process step shown in Figure **1(b)**, a gate oxide film **2**, made of silicon dioxide having a thickness of 5 nm, is formed over the silicon substrate **1** and a polycrystalline silicon film **3** having a thickness of 200 nm is deposited thereon.

Then, in the process step shown in Figure **1(c)**, fluorine ions are implanted into the entire polycrystalline silicon film **3** on the conditions that the implant energy is set at 10 keV and the dose is set at 5 × 10¹⁴ cm⁻².

Subsequently, in the process step shown in Figure **1(d)**, the polycrystalline silicon film **3** and the gate oxide film **2** are patterned, thereby forming gate electrode **3A**, **3B** and gate oxide films **2A**, **2B** for the pMOS and nMOS transistors, respectively. It is noted that the gate oxide film **2** is not necessarily patterned.

Thereafter, in the process step shown in Figure **1(e)**, sidewalls **11**, made of silicon dioxide, are formed on the side surfaces of each gate electrode **3A**, **3B**. And n-type and p-type doped layers **7** and **8**, which are to constitute respective source/drain regions for the nMOS and pMOS transistors, are formed. Then, rapid thermal annealing is conducted at 1000°C for 10 seconds, thereby completing the pMOS and nMOS transistors. As a result of this rapid thermal annealing process, fluorine diffuses from the gate electrodes **3A**, **3B** into the gate oxide films **2A**, **2B**, respectively.

The n-type doped layer **7** is formed by implanting n-type impurity ions such as arsenic (As) into the nMOS transistor forming region **Rn** at an angle substantially vertical to the surface of the substrate on the conditions that the implant energy is set at 30 keV and the dose is set at 2 × 10¹⁵ cm⁻² with the pMOS transistor forming region **Rp** covered with a photoresist mask or the like. During this implantation, the conductivity type of the gate electrode **3B** in the nMOS transistor forming region **Rn** is also turned into n-type. That is to say, the polycrystalline silicon film **3** is turned into an n-type polycrystalline silicon film. On the other hand, the p-type doped layer **8** is formed by implanting p-type impurity ions such as boron (B) into the pMOS transistor forming region **Rp** at an angle substantially vertical to the surface of the substrate on the conditions that the implant energy is set at 8 keV and the dose is set at 2 × 10¹⁵ cm⁻² with the nMOS transistor forming region **Rn** covered with a photoresist mask or the like. During this implantation, the conductivity type of the gate electrode **3A** in the pMOS transistor forming region **Rp** is also turned into p-type. That is to say, the polycrystalline silicon film **3** is turned into a p-type polycrystalline silicon film. In this specification, the ion implantation at the "angle substantially vertical to the surface of the substrate" is performed at a tilt angle of about 7 degrees for preventing channeling. It is noted that though the angle is vertical to the surface of the substrate in the cross section (shown in Figure **1(e)**) including the channel direction of the gate electrodes, the angle is tilted 7 degrees with respect to the surface of the substrate in a cross section parallel to the gate width direction.

In this embodiment, fluorine ions are first introduced into the polycrystalline silicon film **3** to be the gate electrodes **3A** and **3B**. And after the gate electrodes **3A** and **3B** have been formed, a heat treatment is conducted, thereby diffusing fluorine ions from the gate electrodes **3A** and **3B** into the gate oxide films **2A** and **2B**, respectively. In this manner, the physical stress applied on the gate oxide films **2A** and **2B** because of the difference between the thermal expansion coefficient of the gate electrodes **3A**, **3B** and that of the gate oxide films **2A**, **2B** can be reduced in the nMOS and pMOS transistors. As a result, the reliability of the gate oxide films **2A** and **2B** can be improved. In general, if some physical stress is applied onto the gate oxide films **2A** and **2B**, dangling bonds are generated in the gate oxide films **2A** and **2B** and establish an interface state, thereby deteriorating the reliability of the gate oxide films **2A** and **2B**. However, if the dangling bonds are bonded with an appropriate element, then the interface state will disappear.

Moreover, in this embodiment, fluorine ions are implanted at an appropriate dose of 5 × 10¹⁴ cm⁻², and it is possible to prevent boron, which has been introduced into the gate electrode **3A** of the pMOS transistor, from passing through the gate oxide film **2A** to enter the silicon substrate **1**. That is to say, the variation in characteristics of the pMOS transistor can be suppressed.

The reason why these two effects can be simultaneously attained will be described in more detail later. The present inventors found that these two effects are attainable so long as the dose of fluorine ions, derived by converting the dose of an impurity introduced, is in the range from 2 × 10¹³ cm⁻² to 2 × 10¹⁵ cm⁻².

We haven't obtained accurate data on the appropriate doping level of fluorine in the interface between the gate oxide film **2A** and the gate electrode **3A** after the pMOS transistor has been completed. However, the results of the experiments tell us that these two effects are attainable in accordance with the above-described ion implantation conditions.

In this embodiment, fluorine ions are implanted in the process step shown in Figure **1(c)**. Alternatively, fluorine may be naturally introduced into the gate electrode **3A** by implanting any other impurity ions, such as BF₂⁺, containing fluorine. In such a case, the implant dose of the impurity may be set at an arbitrary value so long as the dose of fluorine atoms, derived by converting the dose of the impurity introduced, falls within the above-described range (from 2 × 10¹³ cm⁻² to 2 × 10¹⁵ cm⁻²). The implant energy may also be set at an arbitrary value so long as the impurity does not pass through the gate electrode during the ion implantation. The specific energy value is variable depending on the thickness of the gate electrode. In general, the energy may be 15 keV to 20 keV or less.

Also, even if hydrogen or chlorine is introduced instead of fluorine, the physical stress on the gate oxide films **2A** and **2B** can be reduced and the reliability of the gate oxide films **2A** and **2B** can be improved. This is because even the addition of hydrogen or chlorine can eliminate the interface states resulting from the application of physical stress to the gate oxide films **2A** and **2B**. Hydrogen or chlorine may be introduced through the implantation of some impurity containing hydrogen or chlorine or the diffusion resulting from a heat treatment in a gas containing hydrogen or chlorine.

Following is a modified fabrication process of the first embodiment. First, the same process steps as those shown in Figures **1(a)** and **1(b)** are performed. Then, in the process step shown in Figure **1(c)**, fluorine ions and boron ions are introduced into the polycrystalline silicon film **3** either separately or integrally as boron fluoride ions. After the process step shown in Figure **1(c)** has been performed, a protective insulating film such as a silicon dioxide film is formed on the polycrystalline silicon film **3**. Then, the same process steps as those illustrated in Figures **1(d)** and **1(e)** are performed with the gate electrodes **3A** and **3B** covered with the protective oxide film. In such a fabrication process, the doping levels of boron in the gate electrodes **3A** and **3B** and in the silicon substrate **1** can be advantageously controlled independently at respectively appropriate values. Also, in such a case, a dual-gate-type cMOS transistor may be formed by performing independent ion implantation processes using masks in such a manner that boron is introduced into the polycrystalline silicon film **3** in the pMOS transistor forming region **Rp** and that phosphorus or arsenic is introduced into the polycrystalline silicon film **3** in the nMOS transistor forming region **Rn**.

### EMBODIMENT 2

In this embodiment, a semiconductor device, in which pMOS transistors and nMOS transistors coexist, will be described.

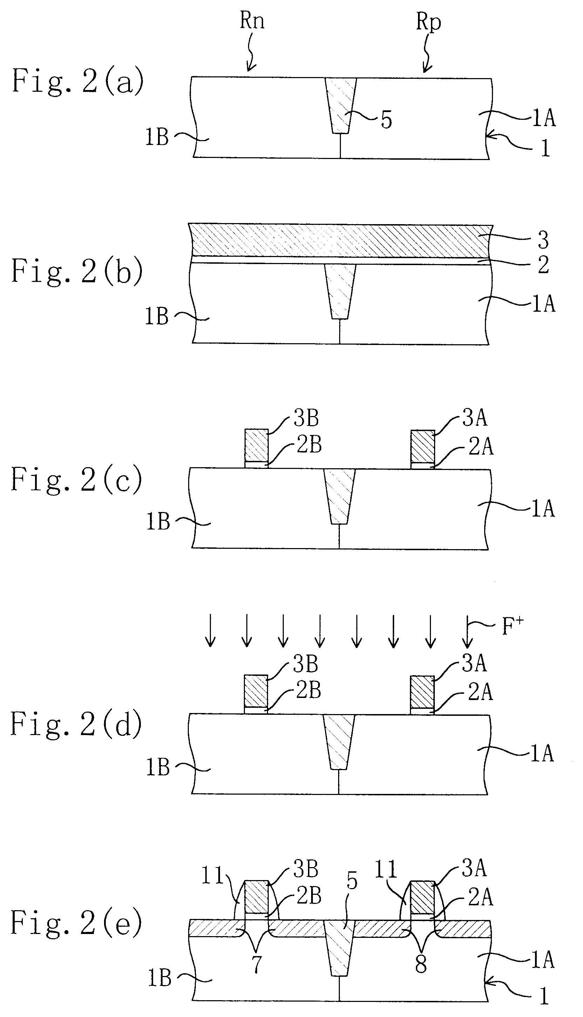

Figures **2(a)** through **2(e)** are cross-sectional views illustrating a method for fabricating a semiconductor device in the second embodiment of the present invention.

First, in the process step shown in Figure **2(a)**, an n-well **1A** and a p-well **1B** are formed as in the first embodiment in the pMOS transistor forming region **Rp** and the nMOS transistor forming region **Rn** of a silicon substrate **1**, respectively. Then, an element isolation region **5** is formed to electrically isolate these regions from each other.

Next, in the process step shown in Figure **2(b)**, a gate oxide film **2**, having a thickness of 5 nm, is formed over the silicon substrate **1** and a polycrystalline silicon film **3** having a thickness of 200 nm is deposited thereon.

Then, in the process step shown in Figure **2(c)**, the polycrystalline silicon film **3** and the gate oxide film **2** are patterned, thereby forming gate electrodes **3A**, **3B** and gate oxide films **2A**, **2B** for the pMOS and nMOS transistors, respectively. It is noted that the gate oxide film **2** is not necessarily patterned.

Subsequently, in the process step shown in Figure **2(d)**, fluorine ions are implanted into the entire substrate at an angle substantially vertical to the surface of the substrate on the conditions that the implant energy is set at 10 keV and the dose is set at 5 × 10¹⁴ cm⁻².

Thereafter, in the process step shown in Figure **2(e)**, sidewalls **11**, made of silicon dioxide, are formed on the side surfaces of each gate electrode **3A**, **3B** as in the first embodiment. And n-type and p-type doped layers **7** and **8**, which are to constitute respective source/drain regions for the nMOS and pMOS transistors, are formed. Then, rapid thermal annealing is conducted at 1000°C for 10 seconds, thereby completing the pMOS and nMOS transistors. As a result of this rapid thermal annealing process, fluorine diffuses from the gate electrodes **3A**, **3B** into the gate oxide films **2A**, **2B**.

The n-type and p-type doped layers **7** and **8** are formed in the same way as in the first embodiment.

In this embodiment, the same effects as those attained in the first embodiment are also attainable. In addition, by implanting fluorine ions after forming the gate electrodes **3A** and **3B**, fluorine can be implanted into not only the gate electrodes **3A** and **3B** and the gate oxide films **2A** and **2B** but also the regions in the silicon substrate **1** where the doped layers **7** and **8** are formed. Thus, during the heat treatment conducted as the last process step, it is possible to suppress the diffusion of the impurity in the n-type and p-type doped layers **7** and **8**. As a result, a shallow junction can be formed easily.

In this embodiment, fluorine ions are implanted after the gate electrodes **3A** and **3B** have been formed and before the impurity for forming the n-type and p-type doped layers **7** and **8** is implanted. Alternatively, fluorine ions may be implanted after the impurity for forming the n-type and p-type doped layers **7** and **8** has been implanted. In such a case, rapid thermal annealing is conducted after fluorine ions have been implanted.

It is noted that some impurity ions containing fluorine may be implanted in place of fluorine ions. As in the first embodiment, the dose thereof may be set at such a value as suppressing the passage of boron through the pMOS transistor.

As also described in the first embodiment, even if hydrogen or chlorine is introduced instead of fluorine, the physical stress on the gate oxide films **2A** and **2B** can also be reduced and the reliability of the gate oxide films **2A** and **2B** can also be improved.

### EMBODIMENT 3

In this embodiment, a semiconductor device, in which pMOS transistors and nMOS transistors coexist and each of the transistors has an LDD (lightly doped drain) structure, will be described.

Figures **3(a)** through **3(e)** are cross-sectional views illustrating a method for fabricating a semiconductor device in the third embodiment of the present invention.

First, in the process step shown in Figure **3(a)**, an n-well **1A** and a p-well **1B** are formed as in the first embodiment in the pMOS transistor forming region **Rp** and the nMOS transistor forming region **Rn** of a silicon substrate **1**, respectively. Then, an element isolation region **5** is formed to electrically isolate these regions from each other. Next, a gate oxide film **2**, having a thickness of 5 nm, is formed over the silicon substrate **1** and a polycrystalline silicon film **3** having a thickness of 200 nm is deposited thereon. Then, the polycrystalline silicon film **3** and the gate oxide film **2** are patterned, thereby forming gate electrodes **3A**, **3B** and gate oxide films **2A**, **2B** for the pMOS and nMOS transistors, respectively. It is noted that the gate oxide film **2** is not necessarily patterned. Subsequently, fluorine ions are implanted into the entire substrate at an angle substantially vertical to the surface of the substrate on the conditions that the implant energy is set at 10 keV and the dose is set at 5 × 10¹⁴ cm⁻².

Next, in the process step shown in Figure **3(b)**, a photoresist film **4A** is formed to cover the nMOS transistor forming region **Rn**. Then, boron fluoride (BF₂⁺) ions are implanted into the pMOS transistor forming region **Rp** at an angle substantially vertical to the surface of the substrate with the photoresist film **4A** used as a mask on the conditions that the implant energy is set at 15 keV and the dose is set at 1 × 10¹⁴ cm⁻². In this manner, a p⁻-type doped layer **9**, which is to constitute lightly doped source/drain regions (LDD regions) for the pMOS transistor, is formed.

Thereafter, in the process step shown in Figure **3(c)**, a photoresist film **4B** is formed to cover the pMOS transistor forming region **Rp**. Then, arsenic (As⁺) ions are implanted into the nMOS transistor forming region **Rn** at an angle substantially vertical to the surface of the substrate with the photoresist film **4B** used as a mask on the conditions that the implant energy is set at 15 keV and the dose is set at 1 × 10¹⁴ cm⁻². In this manner, an n⁻-type doped layer **10**, which is to constitute lightly doped source/drain regions (LDD regions) for the nMOS transistor, is formed.

Subsequently, in the process step shown in Figure **3(d)**, sidewalls **11**, made of silicon dioxide, are formed on the side surfaces of each gate electrode **3A**, **3B** as in the first embodiment.

Then, in the process step shown in Figure **3(e)**, an n⁺-type doped layer **12**, which is to constitute highly-doped source/drain regions for the nMOS transistor, and a p⁺-type doped layer **13**, which is to constitute highly-doped source/drain regions for the pMOS transistor, are formed. And rapid thermal annealing is conducted at 1000°C for 10 seconds, thereby completing the pMOS and nMOS transistors. As a result of this rapid thermal annealing process, fluorine diffuses from the gate electrodes **3A**, **3B** into the gate oxide films **2A**, **2B**, respectively.

The n⁺-type and p⁺-type doped layers **12** and **13** are formed in the same way as the n-type and p-type doped layers **7** and **8** of the first and second embodiments.

In this embodiment, in the process step shown in Figure **3(a)**, after the gate electrodes **3A** and **3B** have been formed, fluorine ions are implanted into the entire surface of the substrate on the conditions that the implant energy is set at 10 keV and the dose is set at 5 × 10¹⁴ cm⁻². And in the process step shown in Figure **3(b)**, BF₂⁺ ions are implanted on the conditions that the implant energy is set at 15 keV and the dose is set at 1 × 10¹⁴ cm⁻². That is to say, if the dose of BF₂⁺ ions implanted in the step shown in Figure **3(b)** is added to the dose of fluorine ions implanted in the step shown in Figure **3(a)** and the sum is converted into the dose of fluorine ions alone, fluorine ions have been implanted into the gate electrode **3A** in the pMOS transistor at a dose of 3.5 × 10¹⁴ cm⁻² in total. As will be described later, this implant dose fits in with the conditions for reducing the physical stress on the gate oxide film and for preventing the variation in characteristics of the transistor. Accordingly, in this embodiment, the same effects as those attained in the second embodiment are also attainable even when a semiconductor device including an MOS transistor having an LDD structure is formed.

In this embodiment, fluorine ions are implanted in the process step shown in Figure **3(a)** immediately after the gate electrodes **3A** and **3B** have been formed. Alternatively, after the polycrystalline silicon film has been deposited, fluorine ions may be implanted into the entire polycrystalline silicon film as in the first embodiment. However, if fluorine ions are implanted after the patterns for the gate electrodes **3A** and **3B** have been formed as in this embodiment, then fluorine can be implanted into the silicon substrate **1**, too. Thus, during the heat treatment conducted as the last process step, it is possible to effectively suppress the diffusion of the impurity in the doped layers. As a result, a shallow junction can be formed easily.

Also, in this embodiment, fluorine ions are implanted into the entire substrate in the process step shown in Figure **3(a)**. Alternatively, fluorine ions may be separately implanted into the pMOS transistor forming region **Rp** and the nMOS transistor **Rn** in the process steps shown in Figures **3(b)** and **3(c)**, respectively. By covering the pMOS transistor forming region **Rp** or the nMOS transistor **Rn** with a photoresist mask or the like during the implantation of fluorine ions in this manner, the flexibility of process can be increased for a semiconductor device in which pMOS and nMOS transistors co-exist.

Furthermore, in this embodiment, fluorine ions are implanted immediately after the patterns for the gate electrodes **3A** and **3B** have been formed and before the p-type and n-type impurities are implanted. Alternatively, fluorine ions may be implanted in the process step shown in Figure **3(d)** after all the impurities have been implanted, i.e., after the implantation for forming the n⁺- and p⁺-type doped layers **12** and **13** has been performed. In such a case, rapid thermal annealing is conducted after fluorine ions have been implanted.

It is noted that some impurity ions containing fluorine may be implanted in place of fluorine ions. As in the first embodiment, the dose thereof may be set at such a value as suppressing the passage of boron through the pMOS transistor. The doping level of fluorine in the interface between the gate oxide film **2A**, **2B** and the gate electrode **3A**, **3B** is also set as described in the first embodiment.

Also, in this embodiment, the process step shown in Figure **3(a)** of implanting fluorine ions may be omitted. In such a case, fluorine is not introduced into the gate electrode **3B** of the nMOS transistor. Nevertheless, there is virtually no possibility that As passes from the gate electrode **3B** into the substrate. In the case of omitting the implantation of fluorine ions, however, the concentration of boron fluoride implanted in the process step shown in Figure **3(b)** is preferably rather dense.

As described in the first embodiment, even if hydrogen or chlorine is introduced instead of fluorine, the physical stress on the gate oxide films **2A** and **2B** can also be reduced and the reliability of the gate oxide films **2A** and **2B** can also be improved.

### EMBODIMENT 4

In this embodiment, a semiconductor device, in which pMOS transistors and nMOS transistors coexist and each of the transistors has an LDD structure as in the third embodiment, will be described.

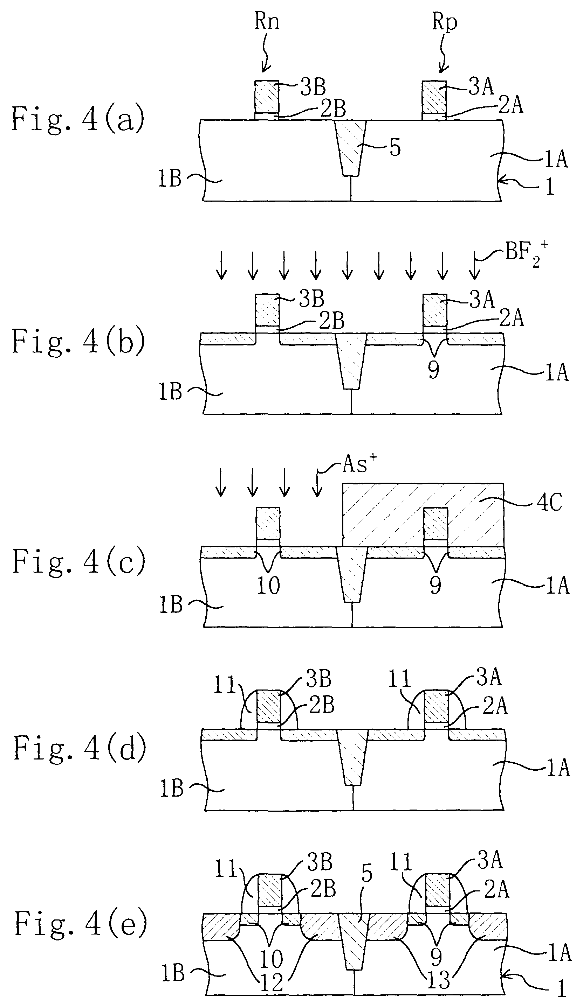

Figures **4(a)** through **4(e)** are cross-sectional views illustrating a method for fabricating a semiconductor device in the fourth embodiment of the present invention.

First, in the process step shown in Figure **4(a)**, an n-well **1A** and a p-well **1B** are formed as in the second embodiment in the pMOS transistor forming region **Rp** and the nMOS transistor forming region **Rn** of a silicon substrate **1**, respectively. Then, an element isolation region **5** is formed to electrically isolate these regions from each other. Next, a gate oxide film **2**, having a thickness of 5 nm, is formed over the silicon substrate **1** and a polycrystalline silicon film **3** having a thickness of 200 nm is deposited thereon. Then, the polycrystalline silicon film **3** and the gate oxide film **2** are patterned, thereby forming gate electrodes **3A**, **3B** and gate oxide films **2A**, **2B** for the pMOS and nMOS transistors, respectively. It is noted that the gate oxide film **2** is not necessarily patterned.

Subsequently, in the process step shown in Figure **4(b)**, boron fluoride (BF₂⁺) ions are implanted into the entire substrate at an angle substantially vertical to the surface of the substrate on the conditions that the implant energy is set at 15 keV and the dose is set at 1 × 10¹⁴ cm⁻², thereby forming a p⁻-type doped layer **9** not only in the pMOS transistor forming region **Rp** but also in the nMOS transistor forming region **Rn**.

Next, in the process step shown in Figure **4(c)**, a photoresist film **4C** is formed to cover the pMOS transistor forming region **Rp**. Thereafter, arsenic (As⁺) ions are implanted into the nMOS transistor forming region **Rn** at an angle substantially vertical to the surface of the substrate with the photoresist film **4C** used as a mask on the conditions that the implant energy is set at 15 keV and the dose is set at 2 × 10¹⁴ cm⁻². In this manner, an n⁻-type doped layer **10** is formed in the nMOS transistor forming region **Rn**. In this case, the dose of arsenic ions is set larger than the dose of boron fluoride ions implanted in the process step shown in Figure **4(b)**.

Thereafter, in the process step shown in Figure **4(d)**, sidewalls **11** are formed on the side surfaces of each gate electrode **3A**, **3B**.

Then, in the process step shown in Figure **4(e)**, an n⁺-type doped layer **12** and a p⁺-type doped layer **13** are formed. And rapid thermal annealing is conducted at 1000°C for 10 seconds, thereby completing the semiconductor device. As a result of this rapid thermal annealing process, fluorine, which has been implanted as boron fluoride in the process step shown in Figure **4(b)**, diffuses from the gate electrodes **3A**, **3B** into the gate oxide films **2A**, **2B**, respectively. The n⁺-type and p⁺-type doped layers **12** and **13** are formed in the same way as the n-type and p-type doped layers **7** and **8** of the first and second embodiments.

In this embodiment, after the patterns for the gate electrodes **3A** and **3B** have been formed, boron fluoride ions are implanted into the entire surface of the substrate. And a heat treatment is conducted, thereby diffusing fluorine from the gate electrodes **3A**, **3B** into the gate oxide films **2A**, **2B**, respectively. In this way, in the nMOS and pMOS transistors having an LDD structure, the physical stress, ordinarily applied on the gate oxide films **2A** and **2B** because of the difference between the thermal expansion coefficient of the gate oxide films and that of the gate electrode **3A**, **3B**, can be reduced. As a result, the reliability of the gate oxide films **2A** and **2B** can be improved. In addition, the variation in characteristics of the pMOS transistor resulting from the passage of boron from the gate electrode **3A** into the silicon substrate **1** can be suppressed.

In particular, the process step shown in Figure **4(b)** of implanting boron fluoride ions after the gate electrodes **3A** and **3B** have been formed also functions as a process step of forming the p⁻-type doped layer **9** for the pMOS transistor having an LDD structure. Thus, the number of process steps can be advantageously reduced.

In the third and the fourth embodiments, even if oxide films, nitride films or the like are used as masks instead of the photoresist films **4A** through **4C**, the same effects can also be attained.

In the process step shown in Figure **4(b)** of implanting boron fluoride ions, if boron fluoride ions are implanted only into the pMOS transistor forming region **Rp** with the nMOS transistor forming region **Rn** covered with a photoresist film or the like, then the dose of the n-type impurity (arsenic, in this embodiment) for forming the n⁻-type doped layer **10** need not be larger than that of boron fluoride.

In the foregoing first to fourth embodiments, the gate oxide film **2** may be an oxide film, an oxide-nitride film, a nitride film, a tantalum oxide film or the like.

Fluorine, introduced into a silicon substrate made of silicon single crystals and a gate electrode made of polycrystalline silicon, is generally regarded as suppressing the diffusion of boron. Nevertheless, fluorine, introduced into a gate oxide film, is generally regarded as promoting the diffusion and passage of boron from the gate electrode into the substrate and thereby varying the characteristics of a transistor. Hereinafter, it will be described how much fluorine should be implanted in order to attain the effects of preventing the variation in characteristics of a transistor owing to the passage of boron and improving the reliability of the gate oxide film.

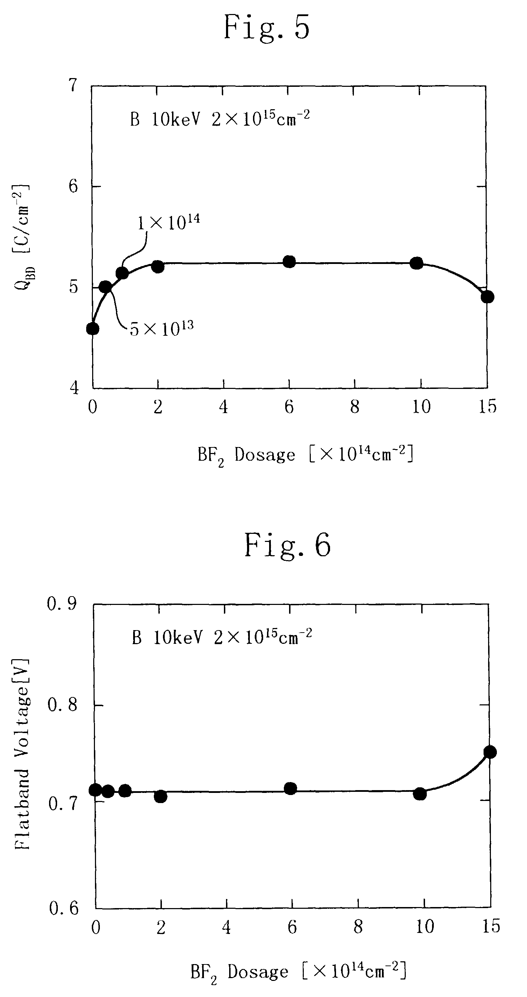

Figure **5** is a graph illustrating the dependence of **Q**_{**BD**} of a surface-channel-type pMOS transistor on the dose of BF₂⁺ ions. In this case, the pMOS transistor is formed by performing substantially the same process steps as those of the third embodiment and includes a gate electrode doped with boron and a gate oxide film having a thickness of 6 nm. In Figure **5**, the axis of abscissas represents the dose of BF₂⁺ ions implanted in the process step shown in Figure **3(b)** of the third embodiment. That is to say, this is the data obtained about the pMOS transistor that has fundamentally the same final cross-sectional structure as that of the pMOS transistor shown in Figure **3(e)** having an LDD structure and that has been formed by implanting BF₂⁺ ions for forming the p⁻-type doped layer **9** and B⁺ ions for forming the p⁺-type doped layer **13** (implant energy: 10 keV; dose: 2 × 10¹⁵ cm⁻²). In Figure **5**, the axis of ordinates represents charge to breakdown **Q**_{**BD**}, which is the total amount of charge implanted into the gate oxide film before the insulation breakdown is caused.

Figure **6** is a graph illustrating the dependence of a flat-band voltage on the dose of BF₂⁺ ions for a surface-channel-type pMOS transistor having the same structure as the pMOS transistor about which the data shown in Figure **5** is obtained.

As shown in Figure **5**, in the range where the dose of BF₂⁺ ions is equal to or smaller than 2 × 10¹⁴ cm⁻², as the amount of fluorine increases, the charge to breakdown **Q**_{**BD**} increases correspondingly. This is presumably because fluorine, which has diffused into the gate oxide film, releases the physical stress in the oxide film. This function will be described in more detail below.

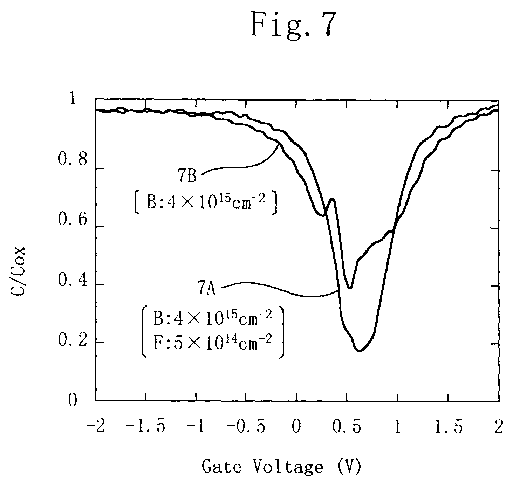

Figure **7** is a graph illustrating how the C-V waveform of an insulated gate portion of an MOS transistor including a gate oxide film with a thickness of 6 nm varies depending upon whether fluorine is implanted into the gate electrode or not. In Figure **7**, the axis of ordinates represents the ratio **C/C**_{**OX**} of the measured capacitance **C** of the gate oxide film to the ideal capacitance **C**_{**OX**} of the gate oxide film, while the axis of abscissas represents a voltage applied to the gate electrode. The data shown in Figure **7** is about a pMOS transistor having fundamentally the same structure as that of the pMOS transistor shown in Figure **1(e)**. However, in this case, the p⁺-type doped layer **13** is formed by implanting B⁺ ions at a dose of 4 × 10¹⁵ cm⁻² and an RTA (rapid thermal annealing) process is performed after the gate electrode has been formed, thereby intentionally applying physical stress on the gate oxide film. In Figure **7**, the C-V waveform **7A** represents the data where B⁺ ions are implanted for forming the p⁺-type doped layer and fluorine ions are implanted at a dose of 5 × 10¹⁴ cm⁻², while the C-V waveform **7B** represents the data where only B⁺ ions are implanted for forming the p⁺-type doped layer and fluorine ions are not implanted. The C-V waveform **7B** has a lot of uneven portions indicating the existence of interface states because of the physical stress. In particular, in the vicinity of a gate voltage of 0.25 V, a remarkable uneven portion indicating the existence of many interface states appears. On the other hand, the C-V waveform **7A** on the sample doped with fluorine has a smooth shape having substantially no uneven portions. Thus, it is estimated that substantially no interface states exist. That is to say, the interface states resulting from the physical stress have presumably disappeared, i.e., the physical stress has probably been released. As can be understood, by diffusing fluorine into the gate oxide film, the physical stress on the gate oxide film can be advantageously released. This effect is not limited to a pMOS transistor, but is attainable in an nMOS transistor as well.

However, if the dose of BF₂⁺ ions is smaller than 2 × 10¹³ cm⁻², the charge to breakdown **Q**_{**BD**} cannot be increased so effectively.

On the other hand, as shown in Figure **5**, it was also found that the charge to breakdown **Q**_{**BD**} decreases to the contrary if the dose of BF₂⁺ ions exceeds 1 × 10¹⁵ cm⁻². This is presumably because the accumulation of boron, which has diffused from the gate electrode **3A** into the gate oxide film **2A** in the pMOS transistor, generates a large quantity of interface states.

Accordingly, the dose of fluorine ions is preferably in the range from 1.0 × 10¹³ cm⁻² to 1.0 × 10¹⁵ cm⁻² when converted into the dose of BF₂⁺ ions. That is to say, fluorine as a single element is preferably implanted in the range from 2 × 10¹³ cm⁻² to 2 × 10¹⁵ cm⁻². Moreover, as can be understood from Figure **5**, the dose of BF₂⁺ ions is more preferably 1 × 10¹⁴ cm⁻² or more.

Also, as shown in Figure **6**, in the range where the dose of BF₂⁺ ions is 1 × 10¹⁵ cm⁻² or less, the flat-band voltage does not change. Thus, it can be understood that boron has not entered the silicon substrate **1**. On the other hand, it can also be understood that if the dose of BF₂⁺ ions exceeds 1 × 10¹⁵ cm⁻², the flat-band voltage increases and the characteristics of a transistor such as the threshold voltage thereof deteriorate.

In the conventional process steps shown in Figures **8(a)** through **8(d)** and disclosed in Japanese Laid-Open Publication No. 9-252117, the total dose of fluorine ions, which are implanted into the gate electrode **103** in the process steps shown in Figures **8(a)** and **8(d)**, is in the range from about 1.1 × 10¹⁵ cm⁻² to 1.01 × 10¹⁶ cm⁻² when converted into the dose of BF₂⁺ ions. Thus, it can be understood that the technology disclosed in the publication cannot prevent the deterioration in reliability of a gate insulating film and the variation in characteristics of a transistor.

In the foregoing embodiments, a gate oxide film is used as a gate insulating film. However, the gate insulating film of the present invention is not limited to a gate oxide film. The gate insulating film may also be an oxide-nitride film, a nitride film, a tantalum oxide film or the like.

## Claims

1. A method for fabricating a semiconductor device, comprising the steps of:
a) sequentially forming a gate insulating film and a semiconductor film over a region of a semiconductor substrate where a pMIS transistor is to be formed;
b) forming a gate electrode for the pMIS transistor by patterning the semiconductor film;
c) introducing an impurity containing fluorine into the gate electrode of the pMIS transistor in accordance with ion implantation technique such that the dose of fluorine is in the range from 2 × 10¹³ cm⁻² to 2 × 10¹⁵ cm⁻² before or after the step b) is performed;
d) introducing boron into the gate electrode of the pMIS transistor;
e) forming source/drain regions for the pMIS transistor by introducing a p-type impurity into the semiconductor substrate; and
f) diffusing fluorine in the gate electrode to the gate insulating film by conducting a heat treatment.

2. The method of Claim 1, wherein the step c) is performed to introduce the impurity containing fluorine into the entire surface of the semiconductor film after the step a) has been performed and before the step b) is performed.

3. The method of Claim 2, wherein the steps c) and d) are performed simultaneously by introducing boron fluoride as the impurity containing fluorine into the entire surface of the semiconductor film after the step a) has been performed and before the step b) is performed,
and wherein the method further comprises the step of forming a protective insulating film over the semiconductor film after the steps c) and d) have been performed,
and wherein in the step b), not only the gate electrode but also the protective insulating film are patterned,
and wherein the step e) is performed by implanting p-type impurity ions with the gate electrode, covered with the protective insulating film, used as a mask.

4. The method of Claim 1, wherein the steps c) and d) are performed simultaneously by introducing boron fluoride as the impurity containing fluorine.

5. The method of Claim 1, wherein the step c) is performed to introduce the impurity containing fluorine into the gate electrode and the semiconductor substrate after the step b) has been performed.

6. The method of Claim 1, wherein the step c) is performed by implanting ions of single-element fluorine,
and wherein the steps d) and e) are performed by introducing single-element boron into the semiconductor substrate with the gate electrode used as a mask after the step b) has been performed.

7. The method of Claim 1, further comprising, prior to the step e), the steps of
forming an LDD region for the pMIS transistor by introducing a p-type impurity into the semiconductor substrate with the gate electrode used as a mask, and
forming insulator sidewalls on side surfaces of the gate electrode of the pMIS transistor,
wherein the step e) is performed by using the insulator sidewalls and the gate electrode as a mask.

8. The method of Claim 1, wherein in the step c), the impurity containing fluorine is introduced in accordance with ion implantation technique such that the dose of fluorine is 2 × 10¹⁴ cm⁻² or more.

9. The method of Claim 1, wherein in the step a), the gate insulating film and the semiconductor film are formed so as to also cover a region of the semiconductor substrate where an nMIS transistor is to be formed,
and wherein in the step b), a gate electrode for the nMIS transistor is formed by patterning the semiconductor film,
and wherein in the step c), the impurity containing fluorine is also introduced in accordance with ion implantation technique into the gate electrode of the nMIS transistor,
and wherein the method further comprises the step of forming source/drain regions for the nMIS transistor by introducing an n-type impurity into the region of the semiconductor substrate where the nMIS transistor is to be formed with the gate electrode for the nMIS transistor used as a mask.

10. A method for fabricating a semiconductor device, comprising the steps of:
a) sequentially forming a gate insulating film and a semiconductor film over respective regions of a semiconductor substrate where nMIS and pMIS transistors are to be formed;
b) forming respective gate electrodes for the nMIS and the pMIS transistors by patterning the semiconductor film;
c) forming p-type lightly-doped source/drain regions in the region where the pMIS transistor is to be formed by introducing boron fluoride into the gate electrodes and the entire semiconductor substrate in accordance with ion implantation technique after the step b) has been performed;
d) forming n-type lightly-doped source/drain regions in the region of the semiconductor substrate where the nMIS transistor is to be formed by introducing an n-type impurity in accordance with ion implantation technique at a level higher than that of boron fluoride;
e) forming insulator sidewalls on side surfaces of each said gate electrode;
f) forming p-type highly-doped source/drain regions in the region of the semiconductor substrate where the pMIS transistor is to be formed by introducing a p-type impurity thereto with the gate electrode and the insulator sidewalls used as a mask;
g) forming n-type highly-doped source/drain regions in the region of the semiconductor substrate where the nMIS transistor is to be formed by introducing an n-type impurity thereto with the gate electrode and the insulator sidewalls used as a mask; and
h) diffusing fluorine in the gate electrodes to the gate insulating film by conducting a heat treatment.

11. The method of Claim 10, wherein in the step b), boron fluoride is introduced in accordance with ion implantation technique at a dose in the range from 1 × 10¹³ cm⁻² to 1 × 10¹⁵ cm⁻².

12. The method of Claim 11, wherein in the step b), boron fluoride is introduced in accordance with ion implantation technique at a dose of 1 × 10¹⁴ cm⁻² or more.

13. The method of Claim 10, wherein in the step f), single-element boron is introduced into the region of the semiconductor substrate where the pMIS transistor is to be formed.
